# EUROPÄISCHE PATENTSCHRIFT

(11) **EP 2 912 207 B1**
(45) Veröffentlichungstag und Bekanntmachung des Hinweises auf die Patenterteilung: **21.09.2016**
(21) Anmeldenummer: 13807896.9
(22) Anmeldetag: 23.10.2013
(51) Int. Cl.: C23C 14/06, C23C 28/00, C23C 14/32

(54) **BAUTEIL MIT EINER BESCHICHTUNG UND VERFAHREN ZU SEINER HERSTELLUNG**
COMPONENT HAVING A COATING AND METHOD FOR THE PRODUCTION THEREOF
COMPOSANT DOTÉ D'UN REVÊTEMENT ET PROCÉDÉ POUR LE FABRIQUER

(30) Priorität: 23.10.2012 DE 102012020756
(43) Veröffentlichungstag der Anmeldung: 02.09.2015
(73) Patentinhaber: MAHLE International GmbH, 70376 Stuttgart (DE)
(72) Erfinder: LEHNERT, Monika, 71686 Remseck (DE); MAIER, Kurt, 71229 Leonberg (DE)
(74) Vertreter: BRP Renaud & Partner mbB Rechtsanwälte Patentanwälte Steuerberater
(86) Internationale Anmeldenummer: PCT/DE2013/000626
(87) Internationale Veröffentlichungsnummer: WO 2014/063677

(56) Entgegenhaltungen:
- EP-A2- 1 413 647
- WO-A2-2007/115419
- DE-A1-102008 062 220

## Beschreibung

Die vorliegende Erfindung betrifft ein Bauteil mit einer Chrom, Stickstoff und Kohlenstoff enthaltenden Beschichtung.

Beschichtungen aus Chromnitrid, erzeugt mit PVD-Verfahren mit Lichtbogenverdampfung, sind dem Fachmann bekannt. Sie finden bspw. Verwendung auf Bauteilen für Verbrennungsmotoren, insbesondere für Dieselmotoren. Diese Beschichtungen zeigen eine gute Verschleißbeständigkeit und sind bei den im Motorbetrieb am Bauteil herrschenden Temperaturen thermisch stabil.

Ein wichtiges Ziel bei der Entwicklung von Verbrennungsmotoren ist die weitere Reduzierung des Kraftstoffverbrauchs. Hierfür müssen - neben einer Vielzahl anderer Maßnahmen - die Reibungsverluste innerhalb des Verbrennungsmotors verringert werden. Unter anderem wird angestrebt, im Motorbetrieb die Reibung zwischen einzelnen Motorbauteilen zu minimieren.

In der DE 10 2008 062 220 A1 ist eine zweiphasige Beschichtung für Kolbenringe aus Chromcarbid und Kohlenstoff offenbart. Dabei soll der Anteil an Chromcarbiden maximal 80 Atom-% betragen. Der Rest liegt in Form von Graphit als separate Phase vor. Die leichte Spaltbarkeit von Graphit führt jedoch zu Problemen hinsichtlich der mechanischen Stabilität der Beschichtung.

Die WO 2007/115419 offenbart die Abscheidung eines mehrphasigen Schichtwerkstoffes mittels PVD-Lichtbogenverfahren. Dabei kann der Schichtwerkstoff aus Chromcarbid und Kohlenstoff bzw. aus Chromcarbonitrid und Kohlenstoff bestehen, allerdings mit einem Gesamtkohlenstoffanteil von bevorzugt mehr als 40 Atom-%. Derartige Schichten weisen zwar eine geringe Reibung auf, sind jedoch aufgrund ihres hohen Kohlenstoff-Anteils mechanisch relativ instabil und verschleißen daher rasch.

Die Aufgabe der vorliegenden Erfindung besteht darin, ein gattungsgemäßes Bauteil so weiterzuentwickeln, dass seine Beschichtung zu einer Reduzierung der Reibung beiträgt, ohne die Verschleißbeständigkeit und die thermische Belastbarkeit zu beeinträchtigen.

Die Lösung besteht darin, dass die Beschichtung eine Gleitschicht mit einer keramischen Phase und einer Kohlenstoff-Phase aufweist, dass die keramische Phase eine kristalline keramische Phase aus Crₓ(C_{1-y}N_{y}) mit 0,8 ≤ x ≤ 1,2 und y > 0,7 bildet, dass die kristalline keramische Phase und die Kohlenstoff-Phase ein Schichtsystem aus alternierenden Einzelschichten bilden, wobei die Kohlenstoff-Phase Lücken aufweist, die mit der kristallinen keramischen Phase gefüllt sind.

Gegenstand der Erfindung ist ferner ein Verfahren zum Beschichten eines Bauteils mit einer Gleitschicht mit einer keramischen Phase und einer amorphen Phase, wobei mindestens ein Bauteil in einer Vakuumkammer drehbar auf einer auf einem Drehtisch angeordneten Spindel montiert ist. Erfindungsgemäß wird die Gleitschicht durch ein PVD-Verfahren mit Lichtbogenverdampfung aufgetragen, wobei die folgenden Parameter verwendet werden. Als Werkstoffquellen dienen mindestens ein Metalltarget und mindestens ein Kohlenstofftarget, wobei das Verhältnis der Targetströme von Metall zu Kohlenstoff 2 bis 7 beträgt. Die Abscheidetemperatur am Bauteil beträgt 350°C bis 500°C. Die Biasspannung beträgt -50 V bis -150 V. Der Druck in der Vakuumkammer beträgt 0,2 Pa bis 1,0 Pa. Die Atmosphäre in der Vakuumkammer setzt sich aus Stickstoff und Inertgas mit einem Verhältnis des Stickstoffpartialdrucks zum Gesamtdruck von 0,6 bis 1,0 zusammen. Während des Beschichtungsvorgangs beträgt die Rotation des Drehtisches 20 - 40 Umdrehungen pro Minute, während die Rotation der mindestens einen Spindel 5 - 7 Umdrehungen pro einer Umdrehung des Drehtischs beträgt.

Die erfindungsgemäß vorgesehene Gleitschicht zeichnet sich durch mehrere Besonderheiten aus.

Mehrphasige Gleitschichten können entweder in Form einer Laminatstruktur oder in Form eines polykristallinen Gemischs vorliegen. Üblicherweise wird Kohlenstoff (oder seine Bichalkogenide) als eine der Phasen der Gleitschicht gewählt. Für Gleitkörper, bei denen sowohl ein niedriger Reibkoeffizient als auch eine hohe mechanische Stabilität gefordert wird, ergibt sich dabei das folgende Problem.

Wird eine Laminatstruktur aus Kohlenstoff und einem keramischen Werkstoff gewählt, so wird im Einsatz immer der Werkstoff mit der geringeren Scherfestigkeit an der Oberfläche liegen, da die keramische Phase im Reibkontakt abgezogen wird. Diese hat für zahlreiche Anwendungen ungenügende mechanische Eigenschaften, was soweit reichen kann, dass der Verschleißwiderstand von der Laminatstruktur aus Kohlenstoff und keramischem Werkstoff geringer ist als der Verschleißwiderstand von reinen Kohlenstoffschichten. Das Ziel eines Schichtwerkstoffs mit niedrigem Reibkoeffizienten wird zwar erreicht, das Ziel der guten mechanischen Eigenschaften aber verfehlt.

Wird ein polykristallines Gemisch aus Kohlenstoff und einem keramischen Werkstoff gewählt, so kann die resultierende Gleitschicht homogen aus beiden Phasen aufgebaut sein, wenn der Anteil der beiden Phasen jeweils 40 bis 60 Atom-% beträgt. In diesem homogenen Gleitschicht-Werkstoff sind die mechanischen Eigenschaften wie bspw. die Zähigkeit wesentlich vom schwächeren Partner bestimmt, während die Härte eine Mischhärte darstellt. Da Kohlenstoff sehr spröde ist, kann man mit diesen Schichten keinen ausreichenden Abrasiv-Verschleiß erzielen.

Die resultierende Gleitschicht kann aber auch in Form einer Matrix mit Einlagerungen aufgebaut sein. Diese Struktur wird bei Phasenanteilen außerhalb des vorgenannten Bereiches erhalten. Liegt der Anteil der keramischen Phase unter 40 Atom-%, resultiert eine Kohlenstoff-Matrix mit eingelagerten keramischen Partikeln. Liegt der Anteil der keramischen Phase über 60 Atom-%, resultiert eine keramische Matrix mit eingelagerten Kohlenstoff-Partikeln. Für Gleitschichten sind nur Strukturen mit einer keramischen Matrix geeignet. Dabei hat sich gezeigt, dass bei einem Kohlenstoffanteil von mehr als 10 Atom-% die Zähigkeit der Gleitschicht stark abnimmt. Bei dieser Zusammensetzung und Morphologie wird der Reibkoeffizient in etwa um den Volumenprozentanteil des Kohlenstoffs gesenkt. Ein so geringer Gewinn verfehlt das Ziel einer reibungsarmen Schicht.

Die neuartige Struktur der erfindungsgemäßen Gleitschicht zeichnet sich dadurch aus, dass die Einzelschichten der Kohlenstoff-Phase Lücken aufweisen, so dass die Struktur der Einzelschichten einem Lochblech gleicht. Diese Lücken sind mit kristallinem keramischem Werkstoff gefüllt. Diese anisotrope Struktur der Einzelschichten der Kohlenstoff-Phase führt dazu, dass im Reibkontakt Oberflächen entstehen, die zu einem großen Teil von Kohlenstoff bedeckt sind. Zugleich sichert der kristalline keramische Werkstoff gute Werte für die Zähigkeit und Härte der erfindungsgemäß vorgesehenen Gleitschicht.

Die erfindungsgemäße Gleitschicht zeichnet sich also durch einen niedrigen Reibkoeffizienten bei gleichzeitiger hoher mechanischer Stabilität aus.

Beide Phasen sind im Wesentlichen frei von Wasserstoff. Dies bewirkt eine hohe thermische Stabilität der erfindungsgemäß vorgesehenen Gleitschicht.

Vorteilhafte Weiterbildungen ergeben sich aus den Unteransprüchen.

Bevorzugt gilt für die kristalline keramische Matrix aus Crₓ(C_{1-y}N_{y}), dass 0,9 ≤ x ≤ 1,1 und y > 0,8 sind.

Vorzugsweise bildet die kristalline keramische Phase zwischen ihren Einzelschichten Brücken aus, welche die Einzelschichten der kristallinen keramischen Phase miteinander verbinden. Auf diese Weise wird die mechanische Stabilität der Gleitschicht weiter verbessert.

Eine bevorzugte Weiterbildung sieht vor, dass die kristalline keramische Phase und die Kohlenstoff-Phase in Form von Lamellen vorliegen. Hierbei kann die Kohlenstoff-Phase eine Struktur aufweisen, bei der die Lamellen im Wesentlichen parallel zur Oberfläche der Gleitschicht angeordnet sind. Dadurch wird der Reibkoeffizient weiter gesenkt.

Die Gleitschicht weist bevorzugt einen Gesamt-Kohlenstoffgehalt von 8 - 27 Atom-%, besonders bevorzugt von 12 - 20 Atom-% auf. Ein zu niedriger Kohlenstoffgehalt führt zu einem zu geringen Reibkoeffizienten. Ein zu hoher Kohlenstoffgehalt beeinträchtigt die mechanische Stabilität der Gleitschicht des erfindungsgemäßen Bauteils.

Die Dicke der Gleitschicht kann 1 bis 50 µm, bevorzugt 10 bis 30 µm betragen. Diese vergleichsweise großen Dicken sind darstellbar, da die Eigenspannungen der Gleitschicht des erfindungsgemäßen Bauteils relativ gering sind. Die Dicke der Einzelschichten beträgt bevorzugt 1,0 nm bis 4,0 nm.

Die Vickers-Härte der Gleitschicht beträgt vorzugsweise 2000 - 3000 HV 0,05 und/oder der Elastizitätsmodul der Gleitschicht beträgt 200 - 300 GPa, um ihre Verschleißfestigkeit zu optimieren.

Die Gleitschicht weist bevorzugt eine mittlere Rautiefe Rz von weniger als 1 µm und/oder einen Materialanteil Rmr(02) von mehr als 50% und/oder dass einen Materialanteil Rmr(03) von mehr als 70%. Da die keramische Phase relativ hart ist, sollte die Oberfläche der Gleitschicht möglichst wenig Unregelmäßigkeiten aufweisen, die in einem tribologischen System auf den Gegenkörper abrasiv wirken würden. Die Definition und Bestimmung des Materialanteils Rmr sind in der Norm DIN EN ISO 4287 festgelegt.

Der Grundkörper des Bauteils kann bspw. aus Gusseisen oder Stahl bestehen.

Zwischen dem Grundkörper und der Gleitschicht ist bevorzugt eine Haftschicht aus einem metallischen Werkstoff vorgesehen. Diese besteht aus einem Metall oder einer Metalllegierung, z.B. Molybdän, Chrom, Titan, Wolfram, oder Chrom-AluminiumLegierung. Die Haftschicht dient zur Optimierung der Haftung der folgenden Schichten auf dem Grundkörper.

Zwischen der Haftschicht und der Gleitschicht ist vorzugsweise eine Zwischenschicht aus einem Metallnitrid-Werkstoff vorgesehen, bspw. Chromnitrid, Molybdännitrid, Titannitrid oder Chrom-Aluminium-Nitrid. Die Zwischenschicht fungiert als Diffusionssperre. Sie verhindert eine Diffusion von Kohlenstoff in die Haftschicht. Würde Kohlenstoff in die Haftschicht diffundieren, käme es zu einer Bildung von spröden Metallcarbiden an der Grenzzone beider Schichten. Dies hätte eine mechanische Instabilität zur Folge hätte.

Die Haftschicht und die Zwischenschicht weisen bevorzugt eine Dicke von jeweils 0,5 µm bis 4 µm auf. Diese Dicken sind vollkommen ausreichend, so dass ein zu hohes Endgewicht des erfindungsgemäßen Bauteils vermieden wird.

Das erfindungsgemäße Bauteil ist bevorzugt ein Bauteil für einen Verbrennungsmotor, bspw. ein Kolbenring, ein Kolbenbolzen, ein Nocken einer Nockenwelle, ein Ventil, ein Ventilstößel oder ein Kipphebel.

Im Folgenden wird die Erfindung anhand der beigefügten Zeichnungen näher erläutert. Es zeigen in einer schematischen, nicht maßstabsgetreuen Darstellung:
- Figur 1: ein Ausführungsbeispiel eines erfindungsgemäß beschichteten Bauteils im Schnitt;
- Figur 2: die Gleitschicht des Bauteils gemäß Figur 1 in einer perspektivischen Darstellung;
- Figur 3: ein Ausführungsbeispiel einer Vorrichtung zum Beschichten des Bauteils gemäß Figur 1;
- Figur 4: ein Balkendiagramm eines Verschleißtests an einem erfindungsgemäß beschichteten Bauteil und an einem Vergleichsbauteil;

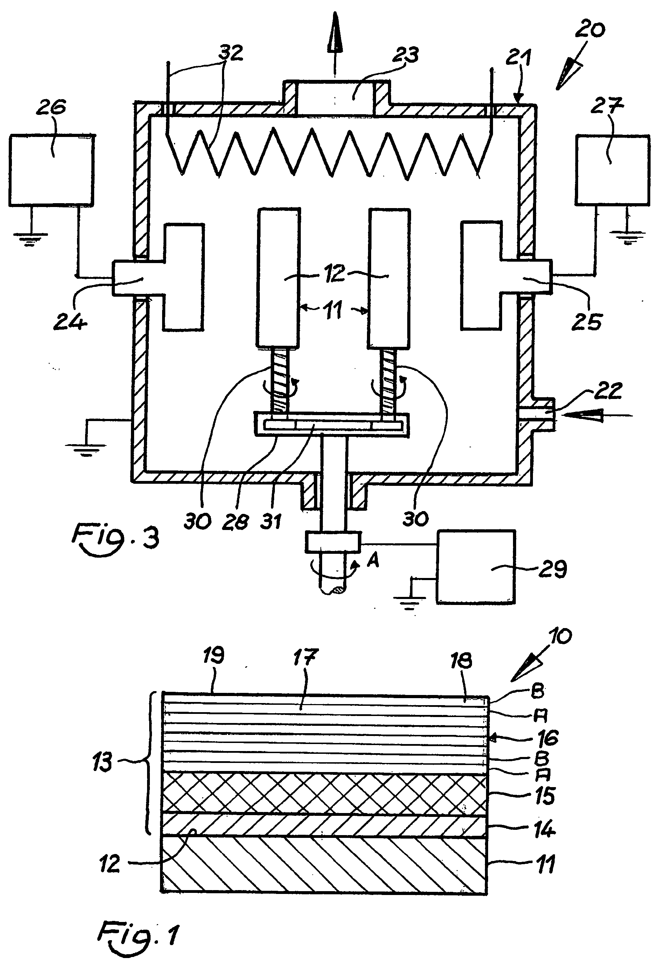

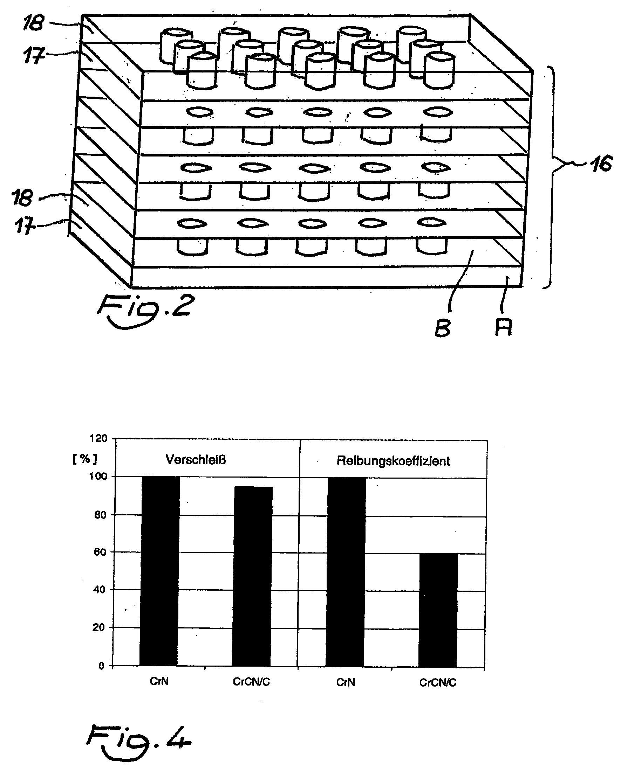

Die Figuren 1 und 2 zeigen eine schematische Darstellung eines Ausführungsbeispiels eines erfindungsgemäß beschichteten Bauteils 10 für einen Verbrennungsmotor, bspw. einen Kolbenring, einen Kolbenbolzen, einen Nocken einer Nockenwelle, einen Ventil, einen Ventilstößel oder einen Kipphebel. Das Bauteil 10 weist einen Grundkörper 11 mit einer beschichteten Oberfläche 12 auf. Der Grundkörper 11 besteht in der Regel aus Stahl oder Gusseisen. Die Oberfläche 12 kann vor dem Beschichten in an sich bekannter Weise nitriert werden. Zur Herstellung einer Beschichtung 13 wird im Ausführungsbeispiel in an sich bekannter Weise eine Haftschicht 14 aus Chrom auf die Oberfläche 12 aufgetragen, bspw. mittels eines PVD-Verfahrens. Auf der Haftschicht 14 ist eine Zwischenschicht 15 aufgebracht, die im Ausführungsbeispiel aus Chromnitrid besteht. Auch die Zwischenschicht kann in an sich bekannter Weise mittels eines PVD-Verfahrens hergestellt werden.

Erfindungsgemäß ist auf der Zwischenschicht 15 eine Gleitschicht 16 aufgetragen. Die Gleitschicht 16 weist eine kristalline keramische Phase 17 und eine Kohlenstoff-Phase 18 auf. Die kristalline keramische Phase 17 besteht aus Chromcarbonitrid Crₓ( C_{1-y} N_{y}), wobei 0,8 ≤ x ≤ 1,2 und y > 0,7 ist. Die Kohlenstoff-Phase 18 besteht zumindest teilweise aus Graphit, dessen Gitterebenen parallel zur Oberfläche 19 der Gleitschicht 16 angeordnet sind. Die kristalline keramische Phase 17 und die Kohlenstoff-Phase 18 liegen in alternierenden Schichten A, B vor, wobei die Schichten A von der kristallinen keramischen Phase 17 und die Schichten B von der Kohlenstoff-Phase 18 gebildet sind. Jede der Schichten A, B weist eine Dicke zwischen 0,5µm und 4,0µm auf. Eine aus der Kohlenstoff-Phase 18 gebildete Schicht B stellt die Oberfläche 19 der Gleitschicht 16 dar.

Zur Herstellung der Beschichtung 13, insbesondere der Gleitschicht 16, wird ein PVD-Verfahren mit Lichtbogenverdampfung verwendet. Figur 3 zeigt schematisch eine Beschichtungsanlage 20, wie sie zur Durchführung dieses Verfahren verwendet werden kann. Der Aufbau dieser Beschichtungsanlage wird nachfolgend beschrieben.

Die Beschichtungsanlage 20 gemäß Figur 3 verfügt über eine Vakuumkammer 21, die eine Gaseinlassöffnung 22 und eine Absaugöffnung 23 aufweist. An den Wänden der Vakuumkammer 21 ist eine elektrische Heizeinrichtung 32 angebracht. Die Vakuumkammer 21 selbst liegt elektrisch auf Masse.

In der Vakuumkammer 21 sind zwei Targets 24, 25 angeordnet. Das erste Target 24 besteht aus metallischem Chrom und ist mit der Kathode einer Stromquelle 26 zur Erzeugung eines Lichtbogens verbunden. Das zweite Target 25 besteht aus Kohlenstoff im Form von Graphit und ist ebenfalls der Kathode einer Stromquelle 27 zur Erzeugung eines Lichtbogens verbunden. Die Targets 24, 25 sind derart angeordnet, dass sie gleich weit von der zu beschichtenden Oberfläche 12 des Grundkörpers 11 des zu beschichtenden Bauteils entfernt sind. Wenn die Vakuumkammer 21 entsprechend groß ist, kann anstelle jeweils eines einzelnen Targets 24, 25 eine Gruppe von Targets vorgesehen sein, wobei die räumliche Anordnung so zu gestalten ist, dass der von den Targets ausgehende Ionenfluss räumlich weitgehend homogen ist.

Ein um den Pfeil A drehbarer Drehtisch 28 ist in der Mitte der Vakuumkammer 21 angeordnet und mit einer Stromquelle 29 für die Erzeugung der Biasspannung elektrisch verbunden. Der Drehtisch 28 weist mehrere, kreisförmig um seinen Mittelpunkt angeordnete Spindeln 30 auf. Auf den Spindeln 30 werden die zu beschichtenden Grundkörper 11 befestigt. Die Spindeln 30 sind drehbar gelagert und werden vom Drehtisch 28 über ein in seinem Innern vorgesehenes Planetengetriebe 31 angetrieben. Das Übersetzungsverhältnis des Planetengetriebes beträgt 5 bis 7.

Im Folgenden wird das Prinzip eines PVD-Beschichtungsverfahrens mit Lichtbogenverdampfung beschrieben.

Nach der Montage der zu beschichtenden Grundkörper 11 auf den Spindeln 30 wird die Vakuumkammer 21 geschlossen und der Druck in der Vakuumkammer 21 auf 0,03 Pa oder weniger reduziert, indem Gas durch die Absaugöffnung 23 abgepumpt wird. Gleichzeitig wir die Heizeinrichtung 32 in Betrieb genommen. Die Heizeinrichtung 32 bewirkt ein Ausgasen, d.h. die Freisetzung von Gasen, die auf der Innenwand der Vakuumkammer 21 und auf den zu beschichtenden Grundkörpern 11 absorbiert sind. Nach dem Abpumpen und Ausheizen wird der Drehtisch 28 in Rotation versetzt und ein Edelgas, in der Regel Argon, durch die Gaseinlassöffnung 22 in die Vakuumkammer 21 eingelassen. Nun werden die Targets 24 aus Chrom in Betrieb genommen. Eine negative Biasspannung von -800 bis -1200 Volt wird über die Stromquelle angelegt. Die von den Targets 24 emittierten Chromionen ionisieren ihrerseits das Argongas. Durch die hohe Biasspannung werden die Ionen stark beschleunigt, treffen mit hoher kinetischer Energie auf die Grundkörper 11 auf und schlagen aus der Oberfläche 12 der Grundkörper 11 die obersten Atomlagen heraus, welche typischerweise aus Oxiden bestehen. Auf diese Weise wird eine Reinigung der zu beschichtenden Oberflächen 12 der Grundkörper 11 durch Ionenbeschuss durchgeführt. Dieser Vorgang wird auch als Ionenätzen bezeichnet.

Danach wird die Biasspannung auf einen niedrigen Wert eingestellt, der Argondruck wird etwas erhöht, und die Stromzufuhr für die Targets 24 aus Chrom wird erhöht. Unter diesen Bedingungen werden mehr Chromionen auf der gereinigten Oberfläche 12 der Grundkörper 11 abgeschieden als durch den Ionenbeschuss abgeätzt werden. Diese verbleibenden Chromionen bilden eine metallische Chromschicht als Haftschicht 14.

Nach einiger Zeit wird bei konstanter Stromzufuhr zu den Targets 24 aus Chrom und bei weiterhin niedriger Biasspannung das Argon durch Stickstoff ersetzt. Stickstoff stellt ein Reaktivgas dar. Innerhalb des in der Kammer brennenden Plasmas wird die N-N-Bindung der Stickstoff-Moleküle aufgebrochen. Die freien Stickstoff-Atome reagieren mit den Chromionen. Das Reaktionsprodukt wird in Form von Chromnitrid als Zwischenschicht 15 auf der Oberfläche der Haftschicht 14 abgeschieden.

Zur Sicherstellung einer guten Haftung der zu bildenden Gleitschicht auf der Zwischenschicht 15 aus Chromnitrid wird im nächsten Schritt unter den oben beschriebenen Bedingungen ein Zwischenätzen durch Ionenbeschuss durchgeführt.

Danach wird die Gleitschicht 16 abgeschieden. Zu diesem Zweck werden Stickstoff und Argon in die Vakuumkammer 21 eingelassen und sowohl die Targets 24 aus Chrom als auch die Targets 25 aus Kohlenstoff in Betrieb genommen. Die Biasspannung wird um ein geringes Maß erhöht.

Der Drehtisch 28 wird in eine schnelle Rotation von 20 - 40 Umdrehungen pro Minute versetzt. Dies ist erforderlich, um die geringen Schichtdicken der Einzelschichten A, B zu erzielen. Bei zu dicken Einzelschichten können sich keine die Einzelschichten A verbindenden Brücken aus der kristallinen keramischen Phase aufbauen.

Für die Einstellung des erfindungsgemäßen Gesamt-Kohlenstoffgehaltes ist das Verhältnis des Kathodenstromes für die Targets 24 aus Chrom zum Kathodenstrom für die Targets 25 aus Kohlenstoff maßgebend. Dieses Verhältnis beträgt 2 bis 7, bevorzugt 3 bis 5.

Die Zusammensetzung der kristallinen keramischen Phase 17 wird im Wesentlichen durch den Stickstoffpartialdruck gesteuert. Ein hoher Stickstoffpartialdruck führt zu einem hohen Stickstoffgehalt in der kristallinen keramischen Phase 17. Das Verhältnis von Stickstoffpartialdruck zu Gesamtdruck soll 0,6 bis 1,0 betragen, bevorzugt 0,7 bis 0,9.

Es ist auch möglich, die Abscheidung der Gleitschicht 16 mit Neon anstelle von Argon durchzuführen. Neon hat eine geringere Atommasse als Argon. Dies wirkt sich auf den als "Resputtering" bekannten Effekt aus. "Resputtering" bedeutet, dass die abzuscheidende Schicht während ihrer Entstehung ständig von Inertgas-Ionen beschossen wird, welche einen Teil der Schichtpartikel, insbesondere weniger fest eingebundene Partikel, wieder abtragen. Die Sputterrate hängt nun von der Masse der Inertgas-Ionen ab. Die leichten Neon-Ionen weisen gegenüber Kohlenstoff eine hohe Sputterrate und gegenüber Chrom bzw. Chromcarbonitrid eine niedrige Sputterate auf, während die Verhältnisse mit den schwereren Argon-Ionen umgekehrt sind. Mit Neon als Inertgas kann man also das Resputtering von Kohlenstoff im Verhältnis zum Resputtering von Chrom bzw. Chromcarbonitrid erhöhen und somit den Mengenanteil der eingelagerten Kohlenstoffpartikel reduzieren. Ferner führt eingelagertes Neon zu geringeren Eigenspannungen als eingelagertes Argon.

Die Gleitschicht 16 weist unter geeigneten Abscheidebedingungen moderate innere Spannungen auf und kann daher in Schichten mit einer Dicke bis zu 50µm abgeschieden werden.

Wenn die gewünschte Schichtdicke erreicht ist, werden die elektrischen Ströme, die Heizung sowie die Gaszufuhr abgeschaltet, und man lässt die Vakuumkammer 21 samt Inhalt abkühlen. Danach kann die Vakuumkammer 21 geöffnet und die beschichteten Bauteile 10 können entnommen werden.

Wie bei einer PVD-Beschichtung durch Lichtbogenverdampfung üblich, weist die Oberfläche der Gleitschicht 16 im Abscheidezustand eine relativ hohe Rauheit auf, die für tribologische Anwendungen ungeeignet ist. Daher wird ein abschließender Finishing-Prozess vorgenommen. Dieser kann, je nach Geometrie der Bauteile 10, durch Schleifen, Honen, Läppen, Polieren oder einer Kombination dieser Verfahren erfolgen. Wesentlich ist, eine glatte Oberfläche mit hohem Traganteil zu erzeugen.

Nachfolgend wird ein Ausführungsbeispiel der vorliegenden Erfindung beschrieben.

Es werden Kolbenringe aus nitriertem Stahl und mit trapezförmigem Querschnitt verwendet. Derartige Kolbenringe und ihre Herstellung sind an sich bekannt, bspw. aus der WO 2005/121609 A1. Vor ihrer Beschichtung werden die Kolbenringe in einem wässrigen Verfahren sorgfältig gereinigt und getrocknet. Danach werden sie in zylinderförmigen Stapeln angeordnet, mit einer Hilfsvorrichtung fixiert, und als Spindeln 30 auf die entsprechenden Plätze des Drehtisches 28 eingesetzt.

Der Drehtisch 28 wird in die Vakuumkammer 21 eingefahren und diese dann verschlossen. Danach wird die Vakuumkammer 21 auf einen Enddruck von höchstens 0,03 Pa evakuiert und auf eine Temperatur von 420°C aufgeheizt. Dies dauert 90 bis 120 Minuten. Wenn die Heiztemperatur zu niedrig ist, ist das Ausgasen unvollständig. Wenn die Heiztemperatur zu hoch ist, können sich die Kolbenringe verformen.

Diese Temperatur wird bis zum Beginn der Abscheidung der Gleitschicht 16 gehalten.

Das erste Ionenätzen erfolgt bei einer Biasspannung von -900 Volt und einem Argondruck von 0,08 Pa. Die Targets 24 aus Chrom werden intermittierend über eine Gesamtzeit von 12 Minuten betrieben, nämlich 30 Sekunden lang bei einem Gesamtstrom von 90 A, gefolgt von 30 Sekunden Pause. Der relativ geringe Anodenstrom sowie die Pausen dienen dazu, ein zu starkes Aufheizen der Kolbenringe zu vermeiden. Dies würde nicht nur zu einer Verformung der Kolbenringe führen, sondern auch zu einem Denitrieren der oberflächennahen Randzone, was die Haftung der nachfolgenden Haftschicht 14 aus Chrom vermindern würde. Auch eine zu hohe Biasspannung würde die Kolbenringe zu stark aufheizen. Umgekehrt würde eine zu niedrige Biasspannung kein zufrieden stellendes Reinigungsergebnis bewirken.

Die Haftschicht 14 aus Chrom wird sodann unter 2 Pa Argondruck, -50 Volt Biasspannung und 480 A Anodenstrom abgeschieden. Innerhalb von 60 Minuten entsteht eine Haftschicht 14 mit einer Dicke von ca. 1,5µm.

Unter den gleichen Bedingungen, nur unter 2 Pa Stickstoffdruck anstelle des Argons, wird anschließend die Zwischenschicht 15 aus Chromnitrid gebildet. Innerhalb von 90 Minuten entsteht eine Zwischenschicht 15 mit einer Dicke von ca. 3µm. Diese Zwischenschicht 15 fungiert unter anderem als Diffusionssperre. Würde man die Gleitschicht 16 direkt auf die metallische Haftschicht 14 aus Chrom abscheiden, so würde Kohlenstoff in die Chromschicht eindiffundieren. In der Grenzzone würden sich Chromcarbide bilden, die zu Adhäsionsproblemen führen würden. Die Zwischenschicht 15 aus Chromnitrid verhindert eine derartige Diffusion und ermöglicht eine gute, mechanisch belastbare Adhäsion der auf ihr aufgetragenen Gleitschicht 16.

Eine weitere Verbesserung der Adhäsion wird erreicht, wenn man an die Abscheidung der Zwischenschicht 15 aus Chromnitrid ein erneutes Ionenätzen anschließt, welches unter den gleichen Bedingungen wie oben beschrieben durchgeführt wird. Durch dieses Ionenätzen werden Chromnitrid-Partikel, die nur lose auf der Oberfläche liegen und die deshalb die Adhäsion beeinträchtigen können, entfernt.

Zur Abscheidung der Gleitschicht 16 werden zu den Targets 24 aus Chrom auch die Targets 25 aus Kohlenstoff in Betrieb genommen. Die folgenden Bedingungen werden eingestellt:

| | |
|---|---|
| Gesamter Anodenstrom für die Chromtargets: | 600 A |
| gesamter Kathodenstrom für die Kohlenstofftargets: | 150 A |
| Biasspannung: | -150 V |
| Gesamtdruck: | 0,4 Pa |
| Verhältnis der Partialdrücke von Stickstoff und Argon: | 0,8 |
| Drehgeschwindigkeit des Drehtischs: | 30 U/min |
| Temperatur der zu beschichtenden Bauteile: | 470°C |

In 7 Stunden wird eine Gleitschicht 16 von ca. 20 µm Dicke abgeschieden.

Die Messung der Vickers-Härte HV 0,05 der erfindungsgemäßen Gleitschicht 16 wurde in an sich bekannter Weise durchgeführt und ergab einen Wert von 1600 HV 0,05. Mittels des an sich bekannten Last-Eindringverfahrens wurde der E-Modul der erfindungsgemäßen Gleitschicht 16 bestimmt. Dabei ergab sich ein Wert von 150 GPa.

Das Endbearbeiten der Kolbenringe erfolgt in einer Kombination von Feinschleifen und Läppen. Zum Feinschleifen wird ein Korund-Schleifpapier mit einer Körnung von 500 eingesetzt. Danach schließt sich ein Läppen mit Diamantpaste von 0,5 µm Körnung an.

Die Auswertung der Oberflächen-Kenngrößen nach DIN EN ISO 4287 ergab eine gemittelte Rautiefe Rz von 0,08, einen Wert für den Materialanteil Rmr 02 von 62% sowie einen Wert für den Materialanteil Rmr 03 von 89%.

Die Schichtstruktur wurde mittels hoch auflösender Transmissions-Elektronenmikroskopie untersucht. Im Hellfeld-Bild der Gleitschicht 16 war eine durchgehende Abfolge von Lamellen zu erkennen, wobei CrCN-Lamellen mit Kohlenstofflamellen abwechseln und so eine Folge von Einzelschichten ABAB bilden. Dieser Lamellenstruktur ist eine weitere Schwankung des Kohlenstoffgehalts überlagert, sodass die Gleitschicht 16 CrCN-Lamellen mit höherem Kohlenstoffgehalt und CrCN-Lamellen mit niedrigerem Kohlenstoffgehalt aufweist. Bei näherer Betrachtung erkannte man, dass die Kohlenstofflamellen aus einzelnen Kohlenstoffpartikeln und kleinen CrCN-Kristallen zu bestehen scheinen. Da es sich jedoch um eine Querschliffaufnahme handelte, sind die Kohlenstoffpartikel ein Bild der Kohlenstofflamelle, die von kleinen CrCN-Kristallen durchwachsen ist. Eine Dunkelfeldaufnahme für Kohlenstoff bzw. Graphit der Gleitschicht 16 in demselben Bereich zeigte wiederum die CrCN-Lamellen und die Kohlenstofflamellen. Wiederum waren die Kohlenstofflamellen als Kohlenstoffpartikel abgebildet, die von Zonen mit niedrigerem Kohlenstoffgehalt unterbrochen waren, bei denen es sich um Bereiche mit hoher Chromkonzentration handelte, also um kleine CrCN-Kristalle.

Bei einem Vergleichstest wurde als Vergleichsbeispiel ein Kolbenring mit einer herkömmlichen Chromnitrid-Schicht herangezogen, der ähnlich wie das Ausführungsbeispiel hergestellt wird. Kolbenringe aus nitriertem Stahl wurden wie oben beschrieben gereinigt, in die Vakuumkammer 21 eingesetzt, geätzt und mit einer Haftschicht aus Chrom versehen. Die Chromnitrid-Schicht wurde unter den gleichen Bedingungen wie beim Ausführungsbeispiel abgeschieden. Lediglich die Beschichtungszeit wurde auf 10 Stunden verlängert. Dabei entstand eine Chromnitrid-Schicht mit einer Dicke von 20 µm und mit einer Vickers-Härte von ca. 1200 HV 0,05. Diese Schicht wurde in analoger Weise wie oben beschrieben mittels Feinschleifen und Läppen endbearbeitet.

Für die Messung der Verschleißbeständigkeit der Kolbenringe gemäß dem Ausführungsbeispiel bzw. gemäß dem Vergleichsbeispiel wurde ein an sich bekanntes Tribometer eingesetzt, das einen reversierenden Gleitverschleiß erzeugt. Als Prüfteile kamen Segmente eines erfindungsgemäß beschichteten Kolbenrings mit Gleitschichten gemäß Figur 1 und Segmente eines gemäß dem Vergleichsbeispiel beschichteten Kolbenrings zum Einsatz. Als Gegenkörper kamen Segmente eines dazu korrespondierenden gehonten Zylinders aus lamellarem Gusseisen zum Einsatz. Mit dieser Prüfanordnung wurde die Bewegung des Kolbenrings im Zylinder abgebildet, und zwar im verschleißrelevanten Bereich des oberen Umkehrpunkts. Dementsprechend wurden die Prüfbedingungen so gewählt, dass bei langsamerer Bewegung und geringstem Schmierölangebot eine hohe Last und damit eine hohe Flächenpressung auf die Versuchsanordnung wirkten, entsprechend dem auf dem Kolbenring im Motorbetrieb lastenden Gasdruck. Die Prüfbedingungen waren im Einzelnen:

| | |
|---|---|
| Testdauer: | 12 Stunden |
| Last: | 1.200 N |
| Flächenpressung: | 57 N/mm² |
| Hub: | 4 mm |
| Geschwindigkeit: | 1,33 m/min |
| Frequenz: | 5 Hz |
| Schmierung: | 0,036g alle 2 Stunden |
| Öl: | Motoröl 5 W 40 |
| Temperatur: | 20°C |

Während des Verschleißtests wurden die dabei auftretenden Reibkräfte gemessen und daraus die Reibungskoeffizienten errechnet. Nach dem Test wurde die Verschleißtiefe an den Kolbenringen und den Gegenkörpern ausgewertet. Diese waren zum Teil sehr gering, so dass ein Weißlicht-Interferometer zur Bestimmung der Profiltiefe eingesetzt wurde.

Bei der Auswertung der Messergebnisse diente die Paarung Chromnitrid - lamellares Gusseisen als Vergleichsbeispiel nach dem Stand der Technik und als Referenz zur Normierung der Daten. Die resultierende Figur 4 zeigt den Vergleich der Werte für Verschleiß und Reibung als Balkendiagramm. Daraus ist zu entnehmen, dass die erfindungsgemäße Gleitschicht 16 gegenüber einer herkömmlichen Chromnitrid-Schicht eine etwas verbesserte Verschleißbeständigkeit und einen deutlich erniedrigten Reibungskoeffizienten aufweist.

## Patentansprüche

1. Bauteil (10) mit einer Chrom, Stickstoff und Kohlenstoff enthaltenden Beschichtung (13), **dadurch gekennzeichnet, dass** die Beschichtung (13) eine Gleitschicht (16) mit einer keramischen Phase (17) und einer Kohlenstoff-Phase (18) aufweist, dass die keramische Phase (17) eine kristalline keramische Phase aus Crₓ(C_{1-y}N_{y}) mit 0,8 ≤ x ≤ 1,2 und y > 0,7 bildet, dass die kristalline keramische Phase (17) und die Kohlenstoff-Phase (18) ein Schichtsystem aus alternierenden Einzelschichten (A, B) bilden, wobei die Kohlenstoff-Phase (18) Lücken (21) aufweist, die mit der kristallinen keramischen Phase (17) gefüllt sind.

2. Bauteil nach Anspruch 1, **dadurch gekennzeichnet, dass** für die kristalline keramische Phase (17) aus Crₓ(C_{1-y}N_{y}) gilt: 0,9 ≤ x ≤ 1,1 und y > 0,8

3. Bauteil nach Anspruch 1, **dadurch gekennzeichnet, dass** die kristalline keramische Phase (17) zwischen ihren Einzelschichten (A) Brücken (22) ausbildet.

4. Bauteil nach Anspruch 1, **dadurch gekennzeichnet, dass** die kristalline keramische Phase (17) und die Kohlenstoff-Phase (18) in Form von Lamellen (41, 42, 43) vorliegen.

5. Bauteil nach Anspruch 4, **dadurch gekennzeichnet, dass** die Lamellen (43) der Kohlenstoff-Phase (18) parallel zur Oberfläche (19) der Gleitschicht (16) angeordnet sind.

6. Bauteil nach Anspruch 1, **dadurch gekennzeichnet, dass** die Gleitschicht (16) einen Gesamt-Kohlenstoffgehalt von 8 bis 27 Atom-% aufweist.

7. Bauteil nach Anspruch 6, **dadurch gekennzeichnet, dass** die Gleitschicht (16) einen Gesamt-Kohlenstoffgehalt von 12 bis 20 Atom-% aufweist.

8. Bauteil nach Anspruch 1, **dadurch gekennzeichnet, dass** die Dicke der Gleitschicht (16) 1 bis 50 µm beträgt.

9. Bauteil nach Anspruch 1, **dadurch gekennzeichnet, dass** die Dicke jeder Einzelschicht (A, B) zwischen 1,0 nm und 4,0 nm beträgt.

10. Bauteil nach Anspruch 1, **dadurch gekennzeichnet, dass** die Vickers-Härte der Gleitschicht (16) 1000 HV 0,05 bis 2000 HV 0,05 beträgt.

11. Bauteil nach Anspruch 1, **dadurch gekennzeichnet, dass** der Elastizitätsmodul der Gleitschicht (16) 100 GPa bis 200 GPa beträgt.

12. Bauteil nach Anspruch 1, **dadurch gekennzeichnet, dass** die Gleitschicht (16) an ihrer Oberfläche eine mittlere Rautiefe Rz von weniger als 1 µm aufweist und/oder dass der Materialanteil Rmr(02) mehr als 50% beträgt und/oder dass der Materialanteil Rmr(03) mehr als 70% beträgt.

13. Bauteil nach Anspruch 1, **dadurch gekennzeichnet**, zwischen dem Grundkörper (11) und der Gleitschicht (16) eine Haftschicht (14) aus einem metallischen Werkstoff aufgebracht ist.

14. Bauteil nach Anspruch 13, **dadurch gekennzeichnet, dass** zwischen der Haftschicht (14) und der Gleitschicht (16) eine Zwischenschicht (15) aus einem Metallnitrid-Werkstoff aufgebracht ist.

15. Bauteil nach Anspruch 1 für einen Verbrennungsmotor, nämlich ein Kolbenring, ein Kolbenbolzen, ein Nocken einer Nockenwelle, ein Ventil, ein Ventilstößel oder ein Kipphebel.

16. Verfahren zum Beschichten eines Bauteils (10) mit einer Gleitschicht (16), wobei mindestens ein Bauteil (10) in einer Vakuumkammer (21) drehbar auf einer auf einem Drehtisch (28) angeordneten Spindel (30) montiert ist, **dadurch gekennzeichnet, dass** zur Herstellung der Gleitschicht (16) ein PVD-Verfahren mit Lichtbogenverdampfung mit den folgenden Parametern verwendet wird:
Werkstoffquellen: mindestens ein Metalltarget (24) und mindestens ein Kohlenstofftarget (25);
Verhältnis der Targetströme Metall zu Kohlenstoff: 2 bis 7;
Abscheidetemperatur am Bauteil (10): 350°C bis 500°C;
Biasspannung: -50 V bis -150 V;
Druck in der Vakuumkammer: 0,2 Pa bis 1,0 Pa;
Atmosphäre in der Vakuumkammer: Stickstoff und Inertgas mit einem Verhältnis des Stickstoffpartialdrucks zum Gesamtdruck von 0,6 bis 1,0;
Rotation des Drehtisches (28): 20 bis 40 Umdrehungen pro Minute Rotation der mindestens einen Spindel (30): 5 bis 7 Umdrehungen pro einer Umdrehung des Drehtischs (28).

## Claims

1. Component (10) having a coating (13) containing chromium, nitrogen and carbon, **characterised in that** the coating (13) comprises a sliding layer (16) having a ceramic phase (17) and a carbon phase (18), **in that** the ceramic phase (17) forms a crystalline ceramic phase from Crₓ(C_{1-y}N_{y}) with 0.8 ≤ x ≤ 1.2 and y > 0.7, and **in that** the crystalline ceramic phase (17) and the carbon phase (18) form a layer system of alternating individual layers (A, B), wherein the carbon phase (18) has interstices (21) that are filled with the crystalline ceramic phase (17).

2. Component according to claim 1, **characterised in that** for the crystalline ceramic phase (17) made from Crₓ(C_{1-y}N_{y}): 0.9 ≤ x ≤ 1.1 and y > 0.8

3. Component according to claim 1, **characterised in that** for the crystalline ceramic phase (17), bridges (22) are formed between the individual layers (A) thereof.

4. Component according to claim 1, **characterised in that** the crystalline ceramic phase (17) and the carbon phase (18) are present in the form of plates (41, 42, 43).

5. Component according to claim 4, **characterised in that** the plates (43) of the carbon phase (18) are arranged parallel to the surface (19) of the sliding layer (16).

6. Component according to claim 1, **characterised in that** the sliding layer (16) has a total carbon content of 8 to 27 at.%.

7. Component according to claim 6, **characterised in that** the sliding layer (16) has a total carbon content of 12 to 20 at.%.

8. Component according to claim 1, **characterised in that** the thickness of the sliding layer (16) is 1 to 50 µm.

9. Component according to claim 1, **characterised in that** the thickness of each individual layer (A, B) is between 1.0 nm and 4.0 nm.

10. Component according to claim 1, **characterised in that** the Vickers hardness of the sliding layer (16) is 1000 HV 0.05 to 2000 HV 0.05

11. Component according to claim 1, **characterised in that** the modulus of elasticity of the sliding layer (16) is 100 GPa to 200 GPa.

12. Component according to claim 1, **characterised in that** the sliding layer (16) has an average surface roughness Rz of less than 1 µm on the surface of same, and/or that the material portion Rmr(02) is greater than 50% and/or that the material portion Rmr(03) is greater than 70%.

13. Component according to claim 1, **characterised in that** a bonding layer (14) made from a metallic material is applied between the main body (11) and the sliding layer (16).

14. Component according to claim 13, **characterised in that** an intermediate layer (15) made from a metal nitride material is applied between the bonding layer (14) and the sliding layer (16).

15. Component according to claim 1 for an internal combustion engine, in particular a piston ring, a piston pin, a cam of a camshaft, a valve, a valve tappet or a rocker arm.

16. Method for coating a component (10) with a sliding layer (16), wherein at least one component (10) is rotatably mounted on a spindle (30) arranged on a turntable (28) in a vacuum chamber (21), **characterised in that** in order to produce the sliding layer (16), a PVD method comprising arc evaporation is employed, having the following parameters: material source: at least one metal target (24) and at least one carbon target (25); ratio of the metal to carbon target flows: 2 to 7; deposition temperature on the component (10): 350 °C to 500 °C; bias voltage -50 V to -150 V; pressure in the vacuum chamber: 0.2 Pa to 1.0 Pa; atmosphere in the vacuum chamber: nitrogen and inert gas with a ratio between the nitrogen partial pressure and the total pressure of 0.6 to 1.0; turntable (28) rotation: 20 to 40 revolutions per minute; rotation of the at least one spindle (30): 5 to 7 revolutions per one revolution of the turntable (28).

## Revendications

1. Composant (10) comprenant un revêtement (13) contenant du chrome, de l'azote et du carbone, **caractérisé en ce que** le revêtement (13) présente une couche de glissement (16) présentant une phase céramique (17) et une phase de carbone (18), **en ce que** la phase céramique (17) forme une phase céramique cristalline composée de Crₓ(C_{1-y}N_{y}) où 0,8 ≤ x ≤ 1,2 et y > 0,7, **en ce que** la phase céramique cristalline (17) et la phase de carbone (18) forment un système stratifié de couches individuelles (A, B) alternées, dans lequel la phase de carbone (18) présente des espaces (21) qui sont remplis par la phase céramique cristalline (17).

2. Composant selon la revendication 1, **caractérisé en ce que** s'applique pour la phase céramique cristalline (17) composée de Crₓ(C_{1-y}N_{y}) : 0,9 ≤ x ≤ 1,1 et y > 0,8.

3. Composant selon la revendication 1, **caractérisé en ce que** la phase céramique cristalline (17) forme des ponts (22) ente ses couches individuelles (A).

4. Composant selon la revendication 1, **caractérisé en ce que** la phase céramique cristalline (17) et la phase de carbone (18) se présentent sous la forme de lamelles (41, 42, 43).

5. Composant selon la revendication 4, **caractérisé en ce que** les lamelles (43) de la phase de carbone (18) sont disposées parallèlement à la surface (19) de la couche de glissement (16).

6. Composant selon la revendication 1, **caractérisé en ce que** la couche de glissement (16) présente une teneur totale en carbone de 8 à 27 % en atomes.

7. Composant selon la revendication 6, **caractérisé en ce que** la couche de glissement (16) présente une teneur totale en carbone de 12 à 20 % en atomes.

8. Composant selon la revendication 1, **caractérisé en ce que** l'épaisseur de la couche de glissement (16) est de 1 à 50 µm.

9. Composant selon la revendication 1, **caractérisé en ce que** l'épaisseur de chaque couche individuelle (A, B) se situe entre 1,0 nm et 4,0 nm.

10. Composant selon la revendication 1, **caractérisé en ce que** la dureté Vickers de la couche de glissement (16) est de 1000 HV 0,5 à 2000 HV 0,5.

11. Composant selon la revendication 1, **caractérisé en ce que** le module d'élasticité de la couche de glissement (16) est de 100 GPa à 200 GPa.

12. Composant selon la revendication 1, **caractérisé en ce que** la couche de glissement (16) présente sur sa surface, une profondeur de rugosité moyenne Rz inférieure à 1 µm et/ou **en ce que** la proportion en matériau Rmr(02) est supérieure à 50 % et/ou **en ce que** la proportion en matériau Rmr(03) est supérieure à 70 %.

13. Composant selon la revendication 1, **caractérisé en ce qu'**une couche adhésive (14) composée d'un matériau métallique est appliquée entre le corps de base (11) et la couche de glissement (16).

14. Composant selon la revendication 13, **caractérisé en ce qu'**une couche intermédiaire (15) composée d'un matériau à base de nitrure métallique est appliquée entre la couche adhésive (14) et la couche de glissement (16).

15. Composant selon la revendication 1 pour un moteur à combustion interne, à savoir, un segment de piston, un axe de piston, une came d'un arbre à cames, une soupape, un poussoir de soupape ou un culbuteur.

16. Procédé pour revêtir un composant (10) d'une couche de glissement (16), dans lequel au moins un composant (10) est monté dans une chambre sous vide (21) de manière à pouvoir tourner sur une broche (30) disposée sur un plateau tournant (28), **caractérisé en ce qu'**est utilisé, afin de fabriquer la couche de glissement (16), un procédé de dépôt physique en phase vapeur (PVD) avec une évaporation d'arc électrique présentant les paramètres suivants :
sources de matériau : au moins une cible métallique (24) et au moins une cible de carbone(25);
rapport des flux cibles métal par rapport au carbone : 2 à 7 ;
température de dépôt au niveau du composant (10) : 350 °C à 500 °C ;
tension de polarisation : -50 V à -150 V ;
pression dans la chambre sous vide : 0,2 Pa à 1,0 Pa ;
atmosphère dans la chambre sous vide : azote et gaz inerte présentant un rapport entre la pression partielle d'azote et la pression totale de 0,6 à 1,0 ;
rotation du plateau tournant (28) : 20 à 40 tours par minute rotation de l'au moins une broche (30) : 5 à 7 tours par tour du plateau tournant (28).
